# FASCICULE DE BREVET EUROPEEN

(11) **EP 2 822 126 B1**
(45) Date de publication et mention de la délivrance du brevet: **27.12.2017**
(21) Numéro de dépôt: 14175810.2
(22) Date de dépôt: 04.07.2014
(51) Int. Cl.: H02H 3/08, H02H 7/08

(54) **Dispositif de protection différentielle pour un appareil de coupure, et appareil de coupure électrique comportant un tel dispositif**
Differenzialschutzvorrichtung für ein Unterbrechungsgerät, und eine solche Vorrichtung umfassendes elektrisches Unterbrechungsgerät
Differential protection device for switchgear, and electrical switchgear comprising such a device

(30) Priorité: 05.07.2013 FR 1356628
(43) Date de publication de la demande: 07.01.2015
(73) Titulaire: Schneider Electric Industries SAS, 92500 Rueil-Malmaison (FR)
(72) Inventeur: Broquie, Vincent, 38050 GRENOBLE CEDEX 9 (FR); Tian, Simon, 38050 GRENOBLE CEDEX 9 (FR); Meunier-Carus, Jérôme, 38050 GRENOBLE CEDEX 9 (FR)
(74) Mandataire: Lavoix

(56) Documents cités:
- EP-A1- 0 039 280
- EP-A1- 1 441 429
- US-A- 4 953 054

## Description

La présente invention concerne un dispositif de protection différentielle pour un appareil de coupure.

L'appareil de coupure comporte au moins deux conducteurs électriques, au moins un contact fixe apte à être connecté à un conducteur électrique correspondant, et au moins un contact mobile, le ou chaque contact mobile étant mobile entre une position fermée, dans laquelle il est relié électriquement au contact fixe correspondant, et une position ouverte, dans laquelle il est isolé électriquement du contact fixe correspondant. L'appareil de coupure comporte également un tore de mesure du courant différentiel entourant les conducteurs électriques, et un actionneur de déclenchement de l'ouverture du ou des contacts mobiles lorsqu'un défaut différentiel est détecté via le tore de mesure. Le dispositif de protection différentielle comprend un organe de commande de l'actionneur.

L'invention concerne également l'appareil de coupure électrique comportant un tel dispositif de protection différentielle connecté au tore de mesure et à l'actionneur de déclenchement.

On connaît du document FR 2 850 495 A1 un dispositif de protection différentielle et un appareil de coupure du type précité. Le dispositif de protection différentielle comprend un circuit intégré relié au tore de mesure du courant différentiel. Le circuit intégré comporte des moyens de comparaison d'un signal représentatif du courant différentiel à un seuil de référence et des moyens de traitement pour commander l'actionneur de déclenchement de l'ouverture des contacts mobiles lorsqu'un défaut différentiel est détecté. Le circuit intégré comporte également des moyens de redressement recevant ledit signal représentatif du courant différentiel et des moyens de filtrage connectés aux moyens de redressement pour filtrer un signal redressé fourni par les moyens de redressement et pour fournir un signal redressé filtré aux moyens de comparaison.

L'actionneur de déclenchement compris dans l'appareil de coupure est un relais de déclenchement, comportant une bobine électromagnétique. Le relais de déclenchement est connecté via des bornes d'alimentation aux conducteurs électriques pour son alimentation, les bornes d'alimentation étant agencées entre le tore de mesure et le ou les contacts mobiles.

L'appareil de coupure électrique est conçu pour être connecté dans un sens précis, à savoir avec la source électrique connectée en amont des contacts mobiles et la charge électrique connectée en aval du tore de mesure du courant différentiel. Autrement dit, lorsque l'appareil de coupure est connecté suivant le sens prévu, les bornes d'alimentation, et en particulier la bobine de l'actionneur, sont agencées entre les contacts mobiles et la charge électrique.

Toutefois, lorsque l'appareil de coupure électrique est connecté à l'envers, c'est-à-dire avec la source électrique connectée en amont des bornes d'alimentation, et en particulier de la bobine de l'actionneur, la charge électrique étant connectée en aval des contacts mobiles, l'apparition d'un défaut électrique est alors susceptible de provoquer la destruction de l'actionneur.

Le but de l'invention est donc de proposer un dispositif de protection différentielle permettant d'éviter une destruction de l'actionneur lors de l'apparition d'un défaut électrique lorsque l'appareil de coupure électrique est connecté à l'envers.

A cet effet, l'invention a pour objet un dispositif de protection différentielle du type précité, dans lequel le dispositif comprend en outre des moyens de mesure d'une grandeur électrique associée à l'organe de commande et des moyens d'inhibition de l'organe de commande lorsque la grandeur électrique mesurée vérifie un critère prédéterminé.

Suivant d'autres aspects avantageux de l'invention, le dispositif de protection différentielle comporte une ou plusieurs des caractéristiques suivantes, prises isolément ou suivant toutes les combinaisons techniquement possibles :
- la grandeur électrique mesurée est un courant propre à circuler dans l'organe de commande ;
- l'organe de commande comporte deux électrodes de conduction et une électrode de commande, et la grandeur électrique mesurée est une tension de l'organe de commande, mesurée entre deux électrodes parmi les électrodes de l'organe de commande ;
- l'organe de commande est un interrupteur statique, de préférence un élément choisi parmi le groupe consistant en : un transistor à effet de champ à grille isolée, un transistor bipolaire, un transistor bipolaire à grille isolée et un thyristor ;
- l'organe de commande est un thyristor, et la jonction entre la gâchette du thyristor et la cathode du thyristor forme une diode, et les moyens de mesure sont propres à mesurer un courant via la tension aux extrémités de ladite diode ;
- l'organe de commande est un transistor, tel qu'un transistor à effet de champ à grille isolée, un transistor bipolaire ou un transistor bipolaire à grille isolée, et les moyens de mesure sont propres à mesurer un courant via la tension entre l'électrode de commande et l'électrode de drain ou d'émetteur dudit transistor ;
- le dispositif comporte des moyens de détection d'un défaut différentiel et de pilotage de l'organe de commande, les moyens de détection et de pilotage étant aptes à être connectés au tore de mesure et à fournir un signal de commande à l'organe de commande lorsqu'un défaut différentiel est détecté, et les moyens d'inhibition sont propres, lorsque la grandeur électrique mesurée vérifie le critère prédéterminé, à inhiber l'organe de commande quel que soit le signal de commande fourni à l'organe de commande par les moyens de détection et de pilotage ;
- les moyens d'inhibition comportent un commutateur connecté en série entre une électrode de commande de l'organe de commande et les moyens de détection et de pilotage, le commutateur étant ouvert pour inhiber l'organe de commande ;
- les moyens d'inhibition comportent un commutateur connecté entre une électrode de commande et une électrode conduction de l'organe de commande, le commutateur étant fermé pour inhiber l'organe de commande ;
- les moyens d'inhibition comportent un transistor à collecteur ouvert, connecté entre une électrode de commande et une électrode conduction de l'organe de commande, le transistor à collecteur ouvert étant passant pour inhiber l'organe de commande ;
- le critère prédéterminé est le dépassement d'un seuil, et le seuil présente une valeur prédéterminée de sorte que l'organe de commande est inhibé par les moyens d'inhibition après que l'actionneur a déclenché l'ouverture des contacts mobiles en cas de détection d'un défaut différentiel ;
- les moyens de mesure comportent un organe de filtrage de la grandeur électrique, l'organe de filtrage comportant de préférence une résistance et un condensateur ; et
- les moyens d'inhibition comportent un comparateur à hystérésis connecté en sortie des moyens de mesure.

L'invention a également pour objet un appareil de coupure électrique, tel qu'un disjoncteur différentiel, comprenant :
- au moins deux conducteurs électriques,
- au moins un contact fixe connecté à un conducteur électrique correspondant,
- au moins un contact mobile, le ou chaque contact mobile étant mobile entre une position fermée, dans laquelle il est relié électriquement au contact fixe correspondant, et une position ouverte, dans laquelle il est isolé électriquement du contact fixe correspondant,
- un tore de mesure du courant différentiel, le tore entourant les conducteurs électriques,
- un actionneur de déclenchement de l'ouverture du ou des contacts mobiles lorsqu'un défaut différentiel est détecté via le tore de mesure, et
- un dispositif de protection différentielle connecté au tore de mesure et à l'actionneur de déclenchement,
dans lequel le dispositif de protection différentielle est tel que défini ci-dessus.

Selon un autre aspect avantageux de l'invention, l'actionneur comporte une bobine électromagnétique, une extrémité de la bobine électromagnétique étant connectée à l'organe de commande.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un appareil de coupure électrique selon l'invention, l'appareil de coupure électrique comprenant deux contacts fixes, deux contacts mobiles, un tore de mesure du courant différentiel entourant deux conducteurs électriques connectés aux deux contacts fixes, un actionneur de déclenchement de l'ouverture des contacts mobiles et un dispositif de protection différentielle connecté au tore de mesure et à l'actionneur de déclenchement,
- la figure 2 est un schéma électrique du dispositif de protection différentielle selon un premier mode de réalisation de l'invention,
- la figure 3 est un ensemble de courbes représentant, d'une part, le courant électrique circulant dans les contacts mobiles, et d'autre part, le courant électrique circulant dans une bobine de l'actionneur de la figure 1,
- les figures 4 et 5 sont des vues analogues à celle de la figure 2 selon des première et deuxième variantes du premier mode de réalisation,
- la figure 6 est une vue analogue à celle de la figure 2 selon un deuxième mode de réalisation de l'invention, le dispositif de protection différentielle comportant un thyristor de commande de l'actionneur, des moyens de pilotage du thyristor de commande, des moyens de mesure de la tension entre la gâchette et la cathode du thyristor et des moyens d'inhibition du thyristor de commande lorsque ladite tension vérifie un critère prédéterminé,
- la figure 7 est une courbe de ladite tension entre la gâchette et la cathode du thyristor de la figure 6,
- la figure 8 est un ensemble de courbes théoriques représentant les tensions respectives en deux bornes d'entrée et en une borne de sortie des moyens d'inhibition de la figure 6, ainsi que la tension de sortie des moyens de pilotage de la figure 6,
- la figure 9 est un ensemble de courbes mesurées représentant, d'une part, le courant électrique circulant dans la bobine de l'actionneur de la figure 1, et d'autre part, les tensions respectives en les deux bornes d'entrée des moyens d'inhibition de la figure 6,
- la figure 10 est une vue analogue à celle de la figure 1 selon un troisième mode de réalisation, l'appareil de coupure électrique comprenant un seul contact fixe et un seul contact mobile,
- la figure 11 est une vue analogue à celle de la figure 1 selon un quatrième mode de réalisation, l'appareil de coupure électrique comprenant trois contacts fixes et trois contacts mobiles, et
- la figure 12 est une vue analogue à celle de la figure 1 selon un cinquième mode de réalisation, l'appareil de coupure électrique comprenant quatre contacts fixes et quatre contacts mobiles, et le dispositif de protection différentielle comportant en outre un interrupteur auxiliaire agissant comme une entrée tout ou rien sur les moyens d'inhibition de la figure 6.

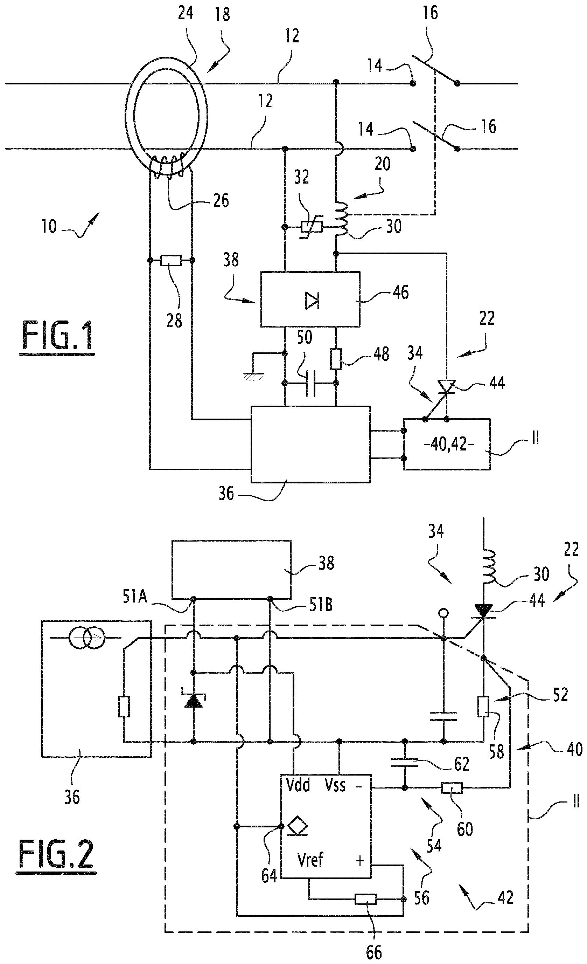

Sur la figure 1, un appareil de coupure électrique 10 comprend au moins deux conducteurs électriques 12, au moins un contact fixe 14 connecté à un conducteur électrique 12 correspondant, et au moins un contact mobile 16, le ou chaque contact mobile 16 étant mobile entre une position fermée, dans laquelle le contact mobile 16 est relié électriquement au contact fixe 14 correspondant, et une position ouverte, dans laquelle le contact mobile 16 est isolé électriquement du contact fixe 14 correspondant.

Dans l'exemple de la figure 1, l'appareil de coupure électrique 10 comprend deux conducteurs électriques 12, à savoir un conducteur de phase et un conducteur de neutre, deux contacts fixes 14 et deux contacts mobiles 16, tous les conducteurs électriques 12, y compris le conducteur de neutre, étant propres à être coupés par l'appareil de coupure 10 dans cet exemple. Autrement dit, l'appareil de coupure 10 de la figure 1 correspond à un appareil monophasé avec coupure du neutre.

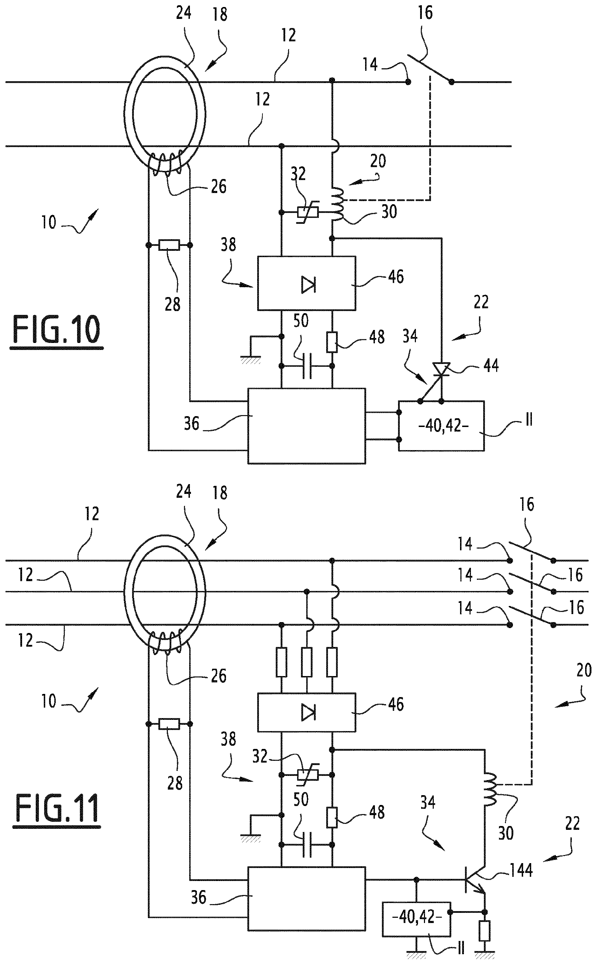

En variante représentée à la figure 10, l'appareil de coupure électrique 10 comprend deux conducteurs électriques 12, à savoir le conducteur de phase et le conducteur de neutre, un seul contact fixe 14 et un seul contact mobile 16, le conducteur de neutre n'étant pas propre à être coupé par l'appareil de coupure 10 selon cette variante. Autrement dit, l'appareil de coupure 10 selon cette variante correspond à un appareil monophasé sans coupure du neutre.

En variante représentée à la figure 11, l'appareil de coupure électrique 10 est un appareil tripolaire avec ou sans coupure du neutre, et comprend trois conducteurs électriques 12, trois contacts fixes 14 et trois contacts mobiles 16. Dans le cas d'un appareil tripolaire sans coupure du neutre, les trois conducteurs électriques 12 sont trois conducteurs de phase, le conducteur de neutre étant à part et n'étant pas connecté à l'appareil tripolaire. Dans le cas d'un appareil tripolaire avec coupure du neutre, les trois conducteurs électriques 12 sont deux conducteurs de phase et un conducteur de neutre.

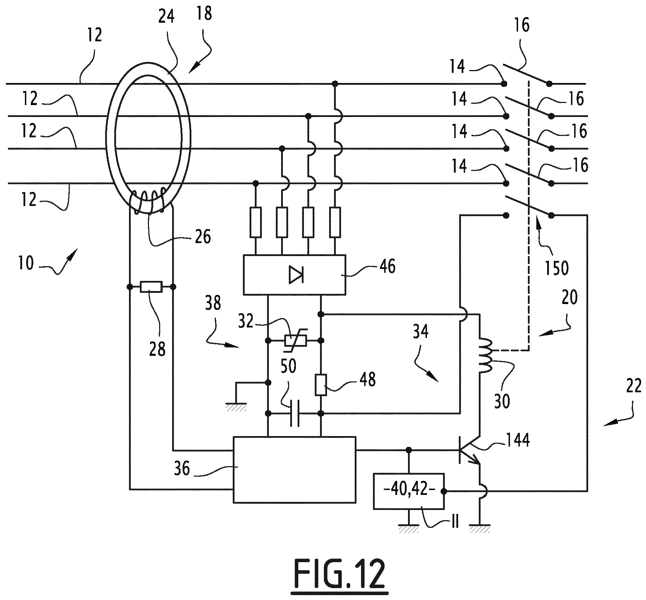

En variante représentée à la figure 12, l'appareil de coupure électrique 10 est un appareil tétrapolaire avec coupure du neutre, et comprend quatre conducteurs électriques 12, quatre contacts fixes 14 et quatre contacts mobiles 16.

En variante non représentée, l'appareil de coupure électrique 10 est un appareil tétrapolaire sans coupure du neutre, et comprend quatre conducteurs électriques 12, trois contacts fixes 14 et trois contacts mobiles 16.

Autrement dit, l'appareil de coupure électrique 10 est un appareil monophasé, tripolaire ou encore tétrapolaire, avec ou sans coupure de neutre, l'absence de coupure du neutre étant possible lorsque l'appareil de coupure 10 est un appareil monophasé ou tétrapolaire.

L'appareil de coupure électrique 10 comprend un tore 18 de mesure du courant différentiel, le tore 18 entourant les conducteurs électriques 12, et un actionneur 20 de déclenchement de l'ouverture des contacts mobiles 16 lorsqu'un défaut différentiel est détecté via le tore de mesure 18.

L'appareil de coupure électrique 10 comprend également un dispositif de protection différentielle 22 connecté au tore de mesure 18 et à l'actionneur de déclenchement 20.

L'appareil de coupure électrique 10 est, par exemple, un disjoncteur différentiel.

Le tore de mesure 18 comprend, par exemple, un enroulement primaire 24 entourant les conducteurs électriques 12, un enroulement secondaire 26 et une résistance de shunt 28 connectée à l'enroulement secondaire 26, la résistance de shunt 28 permettant de transformer le courant circulant dans l'enroulement secondaire 26 en une tension mesurable par un convertisseur analogique - numérique. Le tore de mesure 18 est propre à délivrer une tension alternative au dispositif de protection différentielle 22 via l'enroulement secondaire 26 et la résistance de charge 28.

En variante, le tore de mesure 18 est un tore de Rogowski, et est également propre à délivrer une tension alternative au dispositif de protection différentielle 22.

L'actionneur de déclenchement 20, est par exemple, un relais de déclenchement. Le relais de déclenchement 20 comprend une bobine électromagnétique 30 propre à déclencher le déplacement des contacts mobiles 16 de leur position fermée vers leur position ouverte. Autrement dit, l'actionneur de déclenchement 20 est propre à commander l'ouverture des contacts mobiles 16.

En complément, l'actionneur de déclenchement 20 comprend une varistance 32 de protection contre les surtensions, la varistance 32 étant disposée entre la bobine 30 et le dispositif de protection différentielle 22. La varistance 32 est ainsi propre à protéger le dispositif de protection différentielle 22 contre les surtensions.

Le dispositif de protection différentielle 22 comporte un organe 34 de commande de l'actionneur de déclenchement et des moyens 36 de détection d'un défaut différentiel et de pilotage de l'organe de commande. Le dispositif de protection différentielle 22 comporte également un circuit 38 d'alimentation des moyens de détection et de pilotage.

Selon l'invention, le dispositif de protection différentielle 22 comporte des moyens 40 de mesure d'une grandeur électrique associée à l'organe de commande 34 et des moyens 42 d'inhibition de l'organe de commande lorsque la grandeur électrique mesurée vérifie un critère prédéterminé, comme représenté sur les figures 1 et 2, la zone encadrée II de la figure 1 étant représentée de manière détaillée sur la figure 2.

L'organe de commande 34 est connecté à une extrémité de la bobine électromagnétique 30, l'autre extrémité de la bobine électromagnétique 30 étant connectée à un conducteur électrique 12 correspondant.

Dans l'exemple de réalisation décrit, l'organe de commande 34 comporte un thyristor 44. En variante, l'organe de commande 34 comporte un transistor à effet de champ à grille isolée, également appelé MOSFET (de l'anglais *Metal Oxide Semiconductor Field Effect Transistor*), un transistor bipolaire, un transistor bipolaire à grille isolée, également appelé IGBT (de l'anglais *Insulated Gate Bipolar Transistor*). L'organe de commande 34 est de préférence constitué d'un interrupteur statique, tel qu'un élément choisi parmi le groupe consistant en : un transistor à effet de champ à grille isolée, un transistor bipolaire, un transistor bipolaire à grille isolée et un thyristor.

L'organe de commande 34 est de manière générale un interrupteur statique et commandable entre un état passant et un état non-passant, et comportant une électrode de commande pour commander notamment l'ouverture de l'interrupteur, c'est-à-dire le passage de son état passant à son état non-passant. L'organe de commande 34 comporte également deux électrodes de conduction pour la circulation du courant lorsque l'interrupteur est dans son état passant.

Lorsque l'organe de commande 34 comporte un thyristor, l'électrode de commande est appelée gâchette, et les électrodes de conduction sont respectivement appelées anode et cathode. L'électrode de commande est appelée grille ou encore électrode de grille, lorsque l'organe de commande 34 comporte un MOSFET ou un IGBT, et l'électrode de commande est appelée base, ou encore électrode de base, lorsque l'organe de commande 34 comporte un transistor bipolaire. Les électrodes de conduction sont respectivement appelées collecteur et émetteur, ou encore électrode de collecteur et électrode d'émetteur, lorsque l'organe de commande 34 comporte un IGBT ou un transistor bipolaire, et les électrodes de conduction sont respectivement appelées source et drain, ou encore électrode de source et électrode de drain, lorsque l'organe de commande 34 comporte un MOSFET.

Les moyens de détection et de pilotage 36 comportent des moyens, non représentés, de comparaison d'un signal représentatif du courant différentiel avec un premier seuil, le signal représentatif étant issu du tore de mesure 18. Les moyens de détection et de pilotage 36 comportent des moyens, non représentés, de traitement pour piloter l'organe de commande 34 lorsqu'un défaut différentiel est détecté par les moyens de comparaison.

En complément, les moyens de détection et de pilotage 36 comportent des moyens de redressement, non représentés, recevant ledit signal représentatif du courant différentiel et des moyens de filtrage, non représentés, connectés aux moyens de redressement pour filtrer un signal redressé fourni par les moyens de redressement et pour fournir un signal redressé filtré aux moyens de comparaison.

Les moyens de détection et de pilotage 36 sont, par exemple, réalisés sous forme d'un circuit intégré dédié.

Le circuit d'alimentation 38 comporte un redresseur 46, connecté d'une part à un conducteur électrique 12, et d'autre part à l'extrémité de la bobine 30 à laquelle est connectée l'organe de commande 34, le redresseur 46 étant propre à redresser la tension alternative issue des conducteurs électriques 12 afin d'alimenter les moyens de détection et de pilotage 36 en tension continue. Le circuit d'alimentation 38 comporte en complément une résistance 48 et un condensateur 50, connecté entre le redresseur 46 et les moyens de détection et de pilotage 36, afin de filtrer la tension issue du redresseur 46 tout en diminuant la valeur de cette tension redressée.

Le circuit d'alimentation 38 comporte deux bornes de sortie 51A, 51B, à savoir une borne positive 51A et une borne négative 51B, propres à délivrer la tension continue aux moyens de détection et de pilotage 36, ainsi qu'aux moyens d'inhibition 42.

Selon le premier mode de réalisation, la grandeur électrique mesurée par les moyens de mesure 40 est un courant propre à circuler dans l'organe de commande 34. Les moyens de mesure 40 comportent alors un organe 52 de mesure du courant circulant dans l'organe de commande, l'organe de mesure étant par exemple propre à fournir une tension dont la valeur est fonction du courant mesuré.

En complément, les moyens de mesure 40 comprennent un organe 54 de filtrage de la grandeur électrique mesurée. Dans l'exemple de réalisation décrit, l'organe de filtrage 54 est un filtre du premier ordre permettant d'obtenir une valeur moyenne de la tension fournie par l'organe de mesure 52.

Les moyens d'inhibition 42 sont propres à inhiber l'organe de commande 34 lorsque la grandeur électrique mesurée vérifie un critère prédéterminé. Le critère prédéterminé est, par exemple, le dépassement d'un deuxième seuil, et le deuxième seuil présente une valeur prédéterminée de telle sorte que l'organe de commande 34 est inhibé par les moyens d'inhibition 42 après que l'actionneur 20 a déclenché l'ouverture des contacts mobiles 16 en cas de détection d'un défaut différentiel.

Par inhibition de l'organe de commande 34, on entend la commande forcée de l'organe de commande 34 vers son état non-passant, quel que soit l'ordre de commande éventuellement reçu par ailleurs de la part des moyens de détection et de pilotage 36. L'inhibition de l'organe de commande 34 permet alors le passage à zéro du courant circulant dans l'actionneur 20, par exemple le passage à zéro du courant circulant dans la bobine électromagnétique 30.

Les moyens d'inhibition 42 comprennent, par exemple, un comparateur à hystérésis 56 connecté en sortie des moyens de mesure 40, afin de comparer la grandeur mesurée issue des moyens de mesure 40 avec le deuxième seuil.

L'anode du thyristor 44 est connectée à la bobine électromagnétique 30. La gâchette du thyristor 44 est connectée, d'une part, aux moyens de détection et de pilotage 36, et d'autre part, aux moyens d'inhibition 42. La cathode du thyristor 44 est connectée aux moyens de mesure 40.

Dans l'exemple de réalisation de la figure 2, l'organe de mesure 52 est propre à mesurer le courant circulant dans le thyristor 44, c'est-à-dire le courant circulant dans la bobine électromagnétique 30. L'organe de mesure 52 comporte, par exemple, une première résistance 58, connectée à la cathode du thyristor 44.

Dans l'exemple de réalisation de la figure 2, l'organe de filtrage 54 comporte une deuxième résistance 60 et un condensateur 62. L'organe de filtrage 54 est également appelé filtre RC. Le condensateur 62 est connecté entre la première résistance 58 et l'entrée inverseuse, repérée par le signe '-', du comparateur à hystérésis 56, et la deuxième résistance 60 est connectée entre la cathode du thyristor 44 et l'entrée inverseuse du comparateur à hystérésis 56.

Le comparateur à hystérésis 56 comporte l'entrée inverseuse, décrite ci-dessus, connectée en sortie de l'organe de filtrage 54, une entrée non-inverseuse, repérée par le signe '+', une borne Vref présentant une tension de référence et une borne de sortie 64, par exemple à collecteur ouvert.

Le comparateur à hystérésis 56 comporte également une première borne d'alimentation Vdd et une deuxième borne d'alimentation Vss, connectées respectivement au circuit d'alimentation 38, comme représenté sur la figure 2.

Le comparateur à hystérésis 56 comporte une troisième résistance 66 connectée entre sa borne Vref et son entrée inverseuse.

Le deuxième seuil de valeur prédéterminée est, par exemple, une tension présente sur l'entrée non-inverseuse du comparateur à hystérésis 56, afin d'être comparée avec une tension qui est fonction de la valeur moyenne de la tension aux bornes de la première résistance 58 et est présente sur l'entrée inverseuse du comparateur à hystérésis 56, ladite valeur moyenne étant issue de l'organe de filtrage 54. Dans l'exemple de réalisation de la figure 2, le deuxième seuil est polarisé par la tension de référence au travers de la troisième résistance 66.

Dans l'exemple de réalisation décrit, la borne de sortie 64 du comparateur est connectée directement à l'organe de commande 34, par exemple directement à la gâchette du thyristor 44.

Le fonctionnement du dispositif de protection différentielle 22 selon ce premier mode de réalisation va désormais être expliqué.

En l'absence d'un courant de défaut différentiel, l'organe de commande 34, en particulier le thyristor 44, n'est pas commandé, et la tension de commande du thyristor 44 est nulle. La tension présente sur l'entrée inverseuse du comparateur à hystérésis 56 est alors nulle, et donc inférieure à la tension présente sur l'entrée non-inverseuse du comparateur 56, l'entrée non-inverseuse étant polarisée à la valeur du deuxième seuil, de valeur strictement positive. La borne de sortie 64 du comparateur à hystérésis 56 est donc dans un état de haute impédance, et l'organe de commande 34 n'est alors pas inhibé.

En présence d'un courant de défaut différentiel et lorsque l'appareil de coupure électrique 10 est connecté à l'envers, c'est-à-dire avec la source électrique connectée en amont du tore de mesure 18 et des contacts mobiles 16, les moyens de détection et de pilotage 36 pilotent l'organe de commande 34, en particulier le thyristor 44, par une commande en courant, et la tension de gâchette du thyristor 44 est alors sensiblement égale à 0,7 V. L'organe de filtrage 54 moyenne alors la tension aux bornes de la première résistance 58, et délivre une tension sur l'entrée inverseuse du comparateur à hystérésis 56 qui est fonction du courant efficace circulant dans la bobine électromagnétique 30. Lorsque le courant dans la bobine électromagnétique 30 augmente, le courant circulant dans le thyristor 44 augmente, et la tension présente sur l'entrée inverseuse du comparateur 56 augmente également jusqu'à devenir supérieure à la valeur du deuxième seuil. La borne de sortie 64 du comparateur à hystérésis 56 passe alors dans un état de basse impédance, ce qui inhibe l'organe de commande 34, en particulier le thyristor 44. Le thyristor 44 s'éteint alors dès le passage à zéro du courant.

Il est à noter que l'organe de commande 34, en particulier le thyristor 44, est alors inhibé par les moyens d'inhibition 42 quel que soit le signal de commande fourni à l'organe de commande 34 par les moyens de détection et de pilotage 36. Autrement dit, lorsque la grandeur électrique mesurée par les moyens de mesure 40 vérifie le critère prédéterminé, tel que le dépassement du deuxième seuil, alors les moyens d'inhibition 42 sont propres à inhiber l'organe de commande 34 quel que soit le signal de commande fourni à l'organe de commande 34 par les moyens de détection et de pilotage 36.

Plus précisément, la tension présente sur l'entrée inverseuse du comparateur à hystérésis 56 devient supérieure à la tension présente sur l'entrée non-inverseuse du comparateur à hystérésis 56 lorsque le courant dans la bobine électromagnétique 30 est suffisant pour obtenir le déclenchement de l'ouverture des contacts mobiles 16 et lorsque l'alternance est négative.

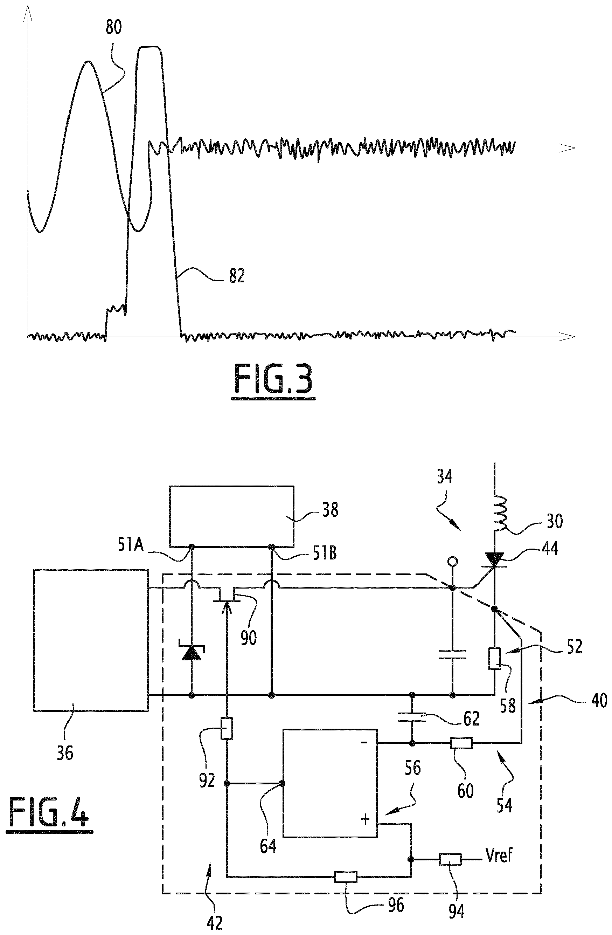

Sur la figure 3, la courbe 80 représente le courant circulant à travers les contacts mobiles 16, et la courbe 82 représente le courant circulant dans la bobine électromagnétique 30. On constate alors que le courant dans la bobine électromagnétique 30 s'annule, de par l'inhibition de l'organe de commande 34 à l'aide des moyens d'inhibition 42, dès la première alternance négative après l'ouverture des contacts mobiles 16, cette ouverture des contacts mobiles 16 étant consécutive au déclenchement commandé par les moyens de détection et de pilotage 36.

Le dispositif de protection différentielle 22 selon l'invention permet alors de limiter l'échauffement de la bobine électromagnétique 30, et d'éviter ainsi une destruction de l'actionneur 20 lors de l'apparition d'un défaut électrique, notamment lorsque l'appareil de coupure électrique 10 est connecté à l'envers.

Le dispositif de protection différentielle 22 est en outre peu coûteux, puisqu'il ne nécessite pas d'ajouter un interrupteur auxiliaire de puissance connecté directement entre les conducteurs électriques 12. Dans l'exemple de réalisation décrit, le dispositif de protection différentielle 22 ne comporte pas d'interrupteur auxiliaire de puissance agencé directement entre les conducteurs électriques 12.

La figure 4 illustre une première variante du premier mode de réalisation pour laquelle les éléments identiques à ceux du premier mode de réalisation, décrit précédemment en regard des figures 1 à 3, sont repérés par des références identiques et ne sont pas décrits à nouveau.

Selon cette première variante, les moyens d'inhibition 42 comportent un commutateur 90 propre à inhiber l'organe de commande 34, le commutateur 90 étant connecté à la borne de sortie 64 du comparateur à hystérésis 56 via une quatrième résistance 92. Le commutateur 90 est connecté en série entre les moyens de détection et de pilotage 36 et la gâchette du thyristor 44.

Le deuxième seuil présent sur l'entrée non-inverseuse du comparateur à hystérésis 56 est polarisé par une tension de référence Vref via une cinquième résistance 94 connectée entre l'entrée non-inverseuse et ladite tension de référence Vref et via une sixième résistance 96 connectée entre la borne de sortie 64 et l'entrée non-inverseuse du comparateur à hystérésis 56.

De manière analogue à ce qui a été décrit précédemment, le deuxième seuil est prédéterminé de telle sorte que l'organe de commande 34 est inhibé par les moyens d'inhibition 42 après que l'actionneur 20 a déclenché l'ouverture des contacts mobiles 16 en cas de détection d'un défaut différentiel.

Le fonctionnement de cette première variante du premier mode de réalisation est analogue à celui décrit précédemment. En effet, en présence d'un courant de défaut différentiel et lorsque l'appareil de coupure électrique 10 est connecté à l'envers, le comparateur à hystérésis 56 détecte le moment où la valeur moyenne de la tension aux bornes de la première résistance 58, tension qui est fonction du courant circulant à travers la bobine électromagnétique 30, dépasse la valeur du deuxième seuil, cette valeur moyenne étant issue de l'organe de filtrage 54. Le comparateur à hystérésis 56 commande alors l'ouverture du commutateur 90 via sa borne de sortie 64, ce qui inhibe l'organe de commande 34, en particulier le thyristor 44. Autrement dit, l'organe de commande 34 est inhibé à l'aide du commutateur 90 via une coupure en série en entrée de la gâchette lorsque l'organe de commande 34 est un thyristor, ou bien via une coupure en série en entrée de la grille ou de la base lorsque l'organe de commande 34 est un transistor, tel qu'un transistor à effet de champ à grille isolée, un transistor bipolaire ou un transistor bipolaire à grille isolée.

Les avantages de cette première variante sont identiques à ceux décrits précédemment pour le premier mode de réalisation, et ne sont pas décrits à nouveau.

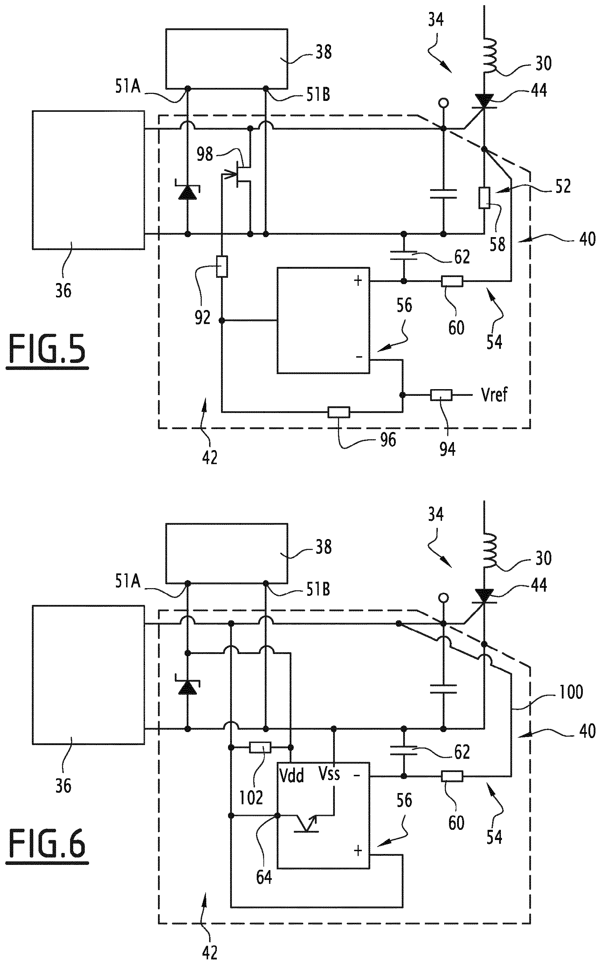

La figure 5 illustre une deuxième variante du premier mode de réalisation pour laquelle les éléments identiques à ceux de la première variante du premier mode de réalisation, décrite précédemment en regard de la figure 4, sont repérés par des références identiques, et ne sont pas décrits à nouveau.

Selon cette deuxième variante, les moyens d'inhibition 42 comportent un commutateur 98 propre à inhiber l'organe de commande 34, le commutateur 98 étant connecté entre la gâchette du thyristor 44 et la borne de sortie négative 51B du circuit d'alimentation.

Le deuxième seuil présent sur l'entrée non-inverseuse du comparateur à hystérésis 56 est également polarisé par la tension de référence Vref via la cinquième résistance 94 connectée entre l'entrée non-inverseuse et ladite tension de référence Vref et la sixième résistance 96 connectée entre la borne de sortie 64 et l'entrée non-inverseuse du comparateur à hystérésis 56.

Le fonctionnement de cette deuxième variante du premier mode de réalisation est analogue à celui de la première variante décrite précédemment, à la différence qu'en présence d'un courant de défaut différentiel et lorsque l'appareil de coupure électrique 10 est connecté à l'envers, le comparateur à hystérésis 56 commande la fermeture du commutateur 98 via sa borne de sortie 64, ce qui inhibe l'organe de commande 34, en particulier le thyristor 44 en reliant la gâchette du thyristor 44 à la borne de sortie négative 51B du circuit d'alimentation. Autrement dit, l'organe de commande 34 est inhibé à l'aide du commutateur 98 via un court-circuit entre la gâchette et la cathode lorsque l'organe de commande 34 est un thyristor, ou bien via un court-circuit entre la grille et le drain, entre la base et l'émetteur, ou respectivement entre la grille et l'émetteur lorsque l'organe de commande 34 est un transistor, tel qu'un transistor à effet de champ à grille isolée, un transistor bipolaire ou respectivement un transistor bipolaire à grille isolée.

Les avantages de cette deuxième variante sont identiques à ceux décrits précédemment pour le premier mode de réalisation, et ne sont pas décrits à nouveau.

Les figures 6 à 9 illustrent un deuxième mode de réalisation de l'invention, pour lequel les éléments identiques à ceux du premier mode de réalisation, décrit précédemment, sont repérés par des références identiques, et ne sont pas décrits à nouveau.

Selon ce deuxième mode de réalisation, la grandeur électrique mesurée par les moyens de mesure 40 est une tension de l'organe de commande 34, mesurée entre deux électrodes parmi les trois électrodes de l'organe de commande 34.

La tension mesurée est, par exemple, la tension de commande de l'organe de commande 34, c'est-à-dire la tension de gâchette, i.e. la tension entre la gâchette et la cathode, lorsque l'organe de commande 34 est un thyristor, ou la tension entre l'électrode de grille et l'électrode d'émetteur lorsque l'organe de commande 34 est un IGBT, ou encore la tension entre l'électrode de grille et l'électrode de drain lorsque l'organe de commande 34 est un MOSFET.

En variante, la tension mesurée est la tension entre l'électrode de collecteur et l'électrode d'émetteur lorsque l'organe de commande 34 est un IGBT, ou encore la tension entre l'électrode de source et l'électrode de drain lorsque l'organe de commande 34 est un MOSFET.

Les moyens de mesure 40 comportent alors un organe 100 de prélèvement de ladite tension.

En complément, les moyens de mesure 40 comprennent l'organe 54 de filtrage de la grandeur électrique mesurée. Dans l'exemple de réalisation de la figure 6, l'organe de filtrage 54 est un filtre du premier ordre permettant d'obtenir une valeur moyenne de la tension prélevée par l'organe de prélèvement 100.

Les moyens d'inhibition 42 sont propres à inhiber l'organe de commande 34 lorsque la grandeur électrique mesurée vérifie un critère prédéterminé. Le critère prédéterminé est, par exemple, le dépassement du deuxième seuil, et le deuxième seuil présente une valeur prédéterminée de telle sorte que l'organe de commande 34 est inhibé par les moyens d'inhibition 42 après que l'actionneur 20 a déclenché l'ouverture des contacts mobiles 16 en cas de détection d'un défaut différentiel.

Les moyens d'inhibition 42 comprennent, par exemple, le comparateur à hystérésis 56 connecté en sortie des moyens de mesure 40, afin de comparer la grandeur mesurée issue des moyens de mesure 40 avec le deuxième seuil.

L'anode du thyristor 44 est connectée à la bobine électromagnétique 30. La gâchette du thyristor 44 est connectée aux moyens de détection et de pilotage 36, aux moyens d'inhibition 42, ainsi qu'à l'organe de prélèvement 100. La cathode du thyristor 44 est connectée au condensateur 62 de l'organe de filtrage.

Dans l'exemple de réalisation de la figure 6, l'organe de prélèvement 100 est en forme d'un fil électrique connecté entre la gâchette du thyristor 44 et la deuxième résistance 60 de l'organe de filtrage.

Dans l'exemple de réalisation de la figure 6, l'organe de filtrage 54 comporte la deuxième résistance 60 et le condensateur 62. Le condensateur 62 est connecté entre la cathode du thyristor 44 et l'entrée inverseuse du comparateur à hystérésis 56, et la deuxième résistance 60 est connectée entre la gâchette du thyristor 44 et l'entrée inverseuse du comparateur à hystérésis 56.

Le comparateur à hystérésis 56 comporte l'entrée inverseuse, connectée en sortie de l'organe de filtrage 54, l'entrée non-inverseuse, et la borne de sortie 64, par exemple à collecteur ouvert. Autrement dit, les moyens d'inhibition 12 comportent un transistor à collecteur ouvert, connecté entre la gâchette du thyristor 44 et la cathode du thyristor 44, le transistor à collecteur ouvert étant passant pour inhiber l'organe de commande 34.

Le comparateur à hystérésis 56 comporte également les première et deuxième bornes d'alimentation Vdd, Vss, connectées au circuit d'alimentation 38.

Le comparateur à hystérésis 56 comporte une septième résistance 102 connectée entre la borne de sortie 64 et la borne d'alimentation Vdd.

Le deuxième seuil de valeur prédéterminée est la tension présente sur l'entrée non-inverseuse du comparateur à hystérésis 56, afin d'être comparée avec la tension qui est fonction de la valeur moyenne de la tension issue de l'organe de prélèvement 100 et est présente sur l'entrée inverseuse du comparateur à hystérésis 56, ladite valeur moyenne étant issue de l'organe de filtrage 54. Dans l'exemple de réalisation de la figure 6, le deuxième seuil est polarisé par la tension d'alimentation du comparateur 56 reçue par la borne Vdd, l'entrée non-inverseuse étant connectée directement à la borne de sortie 64, elle-même connectée à la borne d'alimentation Vdd via la septième résistance 102.

Dans l'exemple de réalisation décrit, la borne de sortie 64 du comparateur est connectée directement à l'organe de commande 34, par exemple directement à la gâchette du thyristor 44.

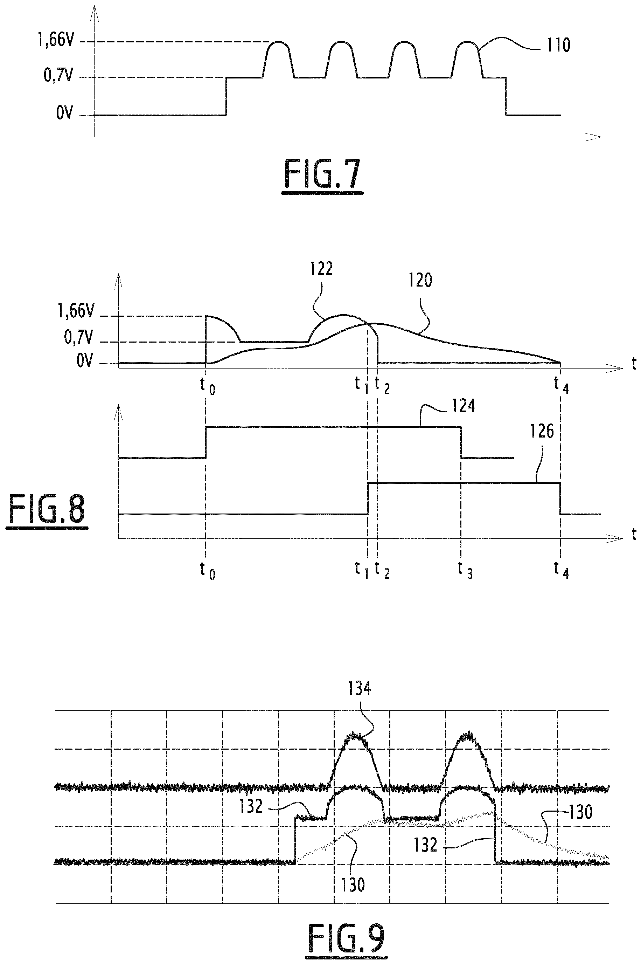

Le fonctionnement du dispositif de protection différentielle 22 selon ce deuxième mode de réalisation va désormais être expliqué à l'aide des figures 7 à 9.

Le dispositif de protection différentielle 22 selon ce deuxième mode de réalisation utilise le fait que la jonction entre la gâchette et la cathode du thyristor correspond à une diode.

Lorsque le thyristor est commandé par application d'un courant de commande sur sa gâchette, la tension entre la gâchette et la cathode est alors une image du courant circulant dans la bobine électromagnétique 30 avec un décalage d'environ 0,7 V correspondant à la tension de diode, la tension entre la gâchette et la cathode correspondant à la courbe théorique 110 visible sur la figure 7.

L'organe de filtrage 54 est, dans l'exemple de réalisation décrit, un filtre du premier ordre et agit comme une moyenne sur la tension de la gâchette. La tension sur l'entrée inverseuse du comparateur 56, représentée par la courbe théorique 120 sur la figure 8, est donc une valeur moyenne de la tension de la gâchette, dont la valeur augmente progressivement jusqu'à dépasser la tension de diode de l'ordre de 0,7 V pour être comprise entre ladite tension de diode et la valeur crête de la tension de gâchette, de l'ordre de 1,6 V.

La tension de gâchette sert également de référence pour le deuxième seuil. La tension sur l'entrée non-inverseuse du comparateur 56, représentée par la courbe théorique 122 sur la figure 8, correspond alors à la tension de gâchette, visible également sur la figure 7.

Sur la figure 8, la courbe théorique 124 représente l'état de la sortie des moyens de détection et de pilotage 36 qui est susceptible de prendre deux valeurs parmi un état bas et un état haut, l'état haut correspondant à la commande de l'organe de commande 34 suite à la détection d'un défaut différentiel et l'état bas correspond à l'absence de commande de l'organe de commande 34 si aucun défaut différentiel n'est détecté.

La courbe théorique 126 représente l'état de la sortie du comparateur 56 qui est susceptible de prendre deux valeurs parmi un état bas et un état haut, l'état haut correspondant au cas où un transistor de sortie à collecteur ouvert du comparateur est en mode passant et la borne de sortie 64 est alors à 0 V, et l'état bas de la courbe 126 correspond au cas où le transistor de sortie à collecteur ouvert du comparateur est en mode bloqué et la borne de sortie 64 est alors en haute impédance. Autrement dit, l'état haut de la courbe 126 correspond à l'inhibition de l'organe de commande 34, et en particulier du thyristor 44, quel que soit le signal de commande fourni à l'organe de commande 34 par les moyens de détection et de pilotage 36. L'état bas de la courbe 126 correspond à une absence d'inhibition de l'organe de commande 34, l'organe de commande 34 étant alors piloté par les moyens de détection et de pilotage 36.

En l'absence d'un courant de défaut différentiel, préalablement à un instant t₀ à la figure 8, l'organe de commande 34, en particulier le thyristor 44, n'est pas commandé (courbe 124 à l'état bas), et la tension de commande du thyristor 44, i.e. la tension de gâchette, est nulle. La tension présente sur l'entrée inverseuse du comparateur à hystérésis 56 est alors nulle, et n'est donc pas supérieure à la tension présente sur l'entrée non-inverseuse du comparateur 56, l'entrée non-inverseuse étant polarisée à la tension de gâchette qui est alors nulle. La borne de sortie 64 du comparateur à hystérésis 56 est donc dans un état de haute impédance, et l'organe de commande 34 n'est alors pas inhibé (courbe 126 à l'état bas).

En présence d'un courant de défaut différentiel et lorsque l'appareil de coupure électrique 10 est connecté à l'envers, c'est-à-dire avec la source électrique connectée en amont du tore de mesure 18 et des contacts mobiles 16, les moyens de détection et de pilotage 36 pilotent l'organe de commande 34, en particulier le thyristor 44, par une commande en courant, et la tension de gâchette du thyristor 44 varie entre 0,7 V et 1,66 V environ. La tension moyennée issue de l'organe de filtrage 54 (courbe 120) augmente progressivement jusqu'à dépasser la tension de gâchette (courbe 122) à un instant t₁ à la figure 8. A cet instant t₁, le dépassement du deuxième seuil est détecté par le comparateur 56. La borne de sortie 64 du comparateur à hystérésis 56 passe alors dans un état de basse impédance, ce qui inhibe l'organe de commande 34, en particulier le thyristor 44 (courbe 126 à l'état haut). Le thyristor 44 s'éteint alors dès le passage à zéro du courant, à un instant t₂ à la figure 8.

Il est à noter qu'à cet instant t₂ la tension de gâchette (courbe 122) est nulle, bien que la sortie des moyens de détection et de pilotage 36 est encore une commande de l'organe de commande 34 (courbe 124 à l'état haut). Autrement dit, l'organe de commande 34 est alors inhibé par les moyens d'inhibition bien l'organe de commande 34 reçoive toujours un signal de commande de la part des moyens de détection et de pilotage 36.

L'organe de filtrage 54 est en outre dimensionné de sorte que la sortie du comparateur 56 reste en état basse impédance, i.e. en inhibition de l'organe de commande 34, suffisamment longtemps pour que la sortie des moyens de détection et de pilotage 36 revienne à l'état bas, à un instant t₃ à la figure 8, avant que la tension moyennée issue de l'organe de filtrage 54 s'annule et que la borne de sortie 64 du comparateur à hystérésis 56 repasse dans un état de haute impédance, à un instant t₄ à la figure 8, l'organe de commande 34 n'étant alors plus inhibé (courbe 126 à l'état bas).

Sur la figure 9, les courbes 130 à 134 illustrent des résultats d'essais effectués, la courbe 130 représentant la tension sur l'entrée inverseuse du comparateur 56, ou encore la tension de commande appliquée sur la gâchette du thyristor 44, la tension de gâchette servant de référence pour le deuxième seuil. La courbe 132 représente la tension sur l'entrée non-inverseuse du comparateur 56, c'est-à-dire la moyenne de la tension de la gâchette issue de l'organe de filtrage 54, et la courbe 134 représente le courant circulant dans la bobine électromagnétique 30. On constate alors que le courant dans la bobine électromagnétique 30 s'annule, de par l'inhibition de l'organe de commande 34 à l'aide des moyens d'inhibition 42, lorsque la tension sur l'entrée inverseuse du comparateur 56 est supérieure à la tension sur l'entrée non-inverseuse du comparateur 56.

Le dispositif de protection différentielle 22 selon ce deuxième mode de réalisation permet donc également de limiter l'échauffement de la bobine électromagnétique 30, et d'éviter ainsi une destruction de l'actionneur 20 lors de l'apparition d'un défaut électrique, notamment lorsque l'appareil de coupure électrique 10 est connecté à l'envers.

Le dispositif de protection différentielle 22 est en outre peu coûteux, puisqu'il ne nécessite pas d'ajouter un interrupteur auxiliaire de puissance connecté directement entre les conducteurs électriques 12. Dans ce deuxième mode de réalisation, le dispositif de protection différentielle 22 ne comporte également pas d'interrupteur auxiliaire de puissance agencé directement entre les conducteurs électriques 12.

La figure 10 illustre un troisième mode de réalisation de l'invention, pour lequel les éléments identiques à ceux du premier ou du deuxième mode de réalisation, décrits précédemment, sont repérés par des références identiques, et ne sont pas décrits à nouveau.

Selon ce troisième mode de réalisation, l'appareil de coupure électrique 10 comprend deux conducteurs électriques 12, à savoir le conducteur de phase et le conducteur de neutre, un seul contact fixe 14 et un seul contact mobile 16, le conducteur de neutre n'étant pas propre à être coupé par l'appareil de coupure 10 selon ce troisième mode de réalisation. Autrement dit, l'appareil de coupure 10 selon ce troisième mode de réalisation correspond à un appareil monophasé sans coupure du neutre.

La grandeur électrique mesurée par les moyens de mesure 40 est le courant propre à circuler dans l'organe de commande 34, tel que décrit précédemment pour le premier mode de réalisation, ou bien la tension de l'organe de commande 34, tel que décrit précédemment pour le deuxième mode de réalisation.

Le fonctionnement de ce troisième mode de réalisation est identique à celui décrit précédemment pour le premier mode de réalisation lorsque la grandeur mesurée est le courant propre à circuler dans l'organe de commande 34, ou bien identique à celui décrit précédemment pour le deuxième mode de réalisation lorsque la grandeur mesurée est la tension de l'organe de commande 34.

Les avantages de ce troisième mode de réalisation sont identiques à ceux décrits précédemment pour les premier et deuxième modes de réalisation.

La figure 11 illustre un quatrième mode de réalisation de l'invention, pour lequel les éléments identiques à ceux du premier ou du deuxième mode de réalisation, décrits précédemment, sont repérés par des références identiques, et ne sont pas décrits à nouveau.

Selon ce quatrième mode de réalisation, l'appareil de coupure électrique 10 comprend trois conducteurs électriques 12, à savoir trois conducteurs de phase, trois contacts fixes 14 et trois contacts mobiles 16. Autrement dit, l'appareil de coupure 10 selon ce quatrième mode de réalisation est un appareil tripolaire avec ou sans coupure du neutre.

Selon ce quatrième mode de réalisation, l'organe de commande 34 est un interrupteur statique et commandable entre un état passant et un état non-passant. L'organe de commande 34 comporte, par exemple, un transistor 144, tel qu'un transistor bipolaire, ou encore un transistor bipolaire à grille isolée, également appelé IGBT (de l'anglais *Insulated Gate Bipolar Transistor*). En variante, l'organe de commande 34 comporte un thyristor.

Selon ce quatrième mode de réalisation, le redresseur 46 est connecté directement aux conducteurs électriques 12, l'actionneur 20 étant alors disposé entre le redresseur 46 et les moyens de détection 36. Dans le cas d'un appareil de coupure triphasée ou tétrapolaire, le fait de connecter la bobine 30 de l'actionneur 20 entre le redresseur 46 et les moyens de détection 36, c'est-à-dire en aval du redresseur 46, permet d'éviter une perturbation de la commande de l'actionneur 20 en cas de perte d'une phase.

Le fonctionnement de ce quatrième mode de réalisation est identique à celui décrit précédemment pour le premier mode de réalisation lorsque la grandeur mesurée est le courant propre à circuler dans l'organe de commande 34, ou bien identique à celui décrit précédemment pour le deuxième mode de réalisation lorsque la grandeur mesurée est la tension de l'organe de commande 34, avec la convention selon laquelle la gâchette du thyristor 44 correspond à l'électrode de grille de l'IGBT 144, l'anode et la cathode du thyristor 44 correspondant respectivement à l'électrode de collecteur et à l'électrode d'émetteur de l'IGBT 144.

Les avantages de ce quatrième mode de réalisation sont identiques à ceux décrits précédemment pour les premier et deuxième modes de réalisation.

La figure 12 illustre un cinquième mode de réalisation de l'invention, pour lequel les éléments identiques à ceux du premier ou du deuxième mode de réalisation, décrits précédemment, sont repérés par des références identiques, et ne sont pas décrits à nouveau.

Selon ce cinquième mode de réalisation, l'appareil de coupure électrique 10 comprend quatre conducteurs électriques 12, à savoir trois conducteurs de phase et un conducteur de neutre, quatre contacts fixes 14 et quatre contacts mobiles 16. Autrement dit, l'appareil de coupure 10 selon ce cinquième mode de réalisation est un appareil tétrapolaire avec coupure du neutre.

Selon ce cinquième mode de réalisation, l'organe de commande 34 est un interrupteur statique et commandable entre un état passant et un état non-passant. L'organe de commande 34 comporte, par exemple, un transistor 144, tel qu'un transistor bipolaire, ou encore un transistor bipolaire à grille isolée, également appelé IGBT (de l'anglais *Insulated Gate Bipolar Transistor*). En variante, l'organe de commande 34 comporte un thyristor.

Selon ce cinquième mode de réalisation, et de manière analogue au quatrième mode de réalisation, le redresseur 46 est connecté directement aux conducteurs électriques 12, l'actionnaire 20 étant alors disposé entre le redresseur 46 et les moyens de détection 36, c'est-à-dire en aval du redresseur 46.

Le dispositif de de protection différentielle 22 comporte également un interrupteur auxiliaire 150 connecté entre le circuit d'alimentation 38 et les moyens d'inhibition 42, l'interrupteur auxiliaire 150 étant commandé par l'actionneur de déclenchement 20. Plus précisément, l'interrupteur auxiliaire 150 est connecté entre, d'une part, une borne commune à la résistance 48 et au condensateur 50 du circuit d'alimentation 38, et d'autre part, au filtre 54. Dans ce cas, la commande de l'interrupteur auxiliaire 150 est inversée par rapport à la commande des contacts mobiles 16 en utilisant un interrupteur 150 normalement ouvert, ou bien la commande de l'interrupteur auxiliaire 150 n'est pas inversée par rapport à la commande des contacts mobiles 16 en utilisant un interrupteur 150 normalement fermé et les entrées du comparateur 56 sont alors permutées.

Le fonctionnement de ce cinquième mode de réalisation est par ailleurs identique à celui décrit précédemment pour le premier mode de réalisation lorsque la grandeur mesurée est le courant propre à circuler dans l'organe de commande 34, ou bien identique à celui décrit précédemment pour le deuxième mode de réalisation lorsque la grandeur mesurée est la tension de l'organe de commande 34, avec la convention selon laquelle la gâchette du thyristor 44 correspond à l'électrode de grille de l'IGBT 144, l'anode et la cathode du thyristor 44 correspondant respectivement à l'électrode de collecteur et à l'électrode d'émetteur de l'IGBT 144.

Les avantages de ce cinquième mode de réalisation sont identiques à ceux décrits précédemment pour les premier et deuxième modes de réalisation.

L'interrupteur auxiliaire 150 forme une entrée tout ou rien pour les moyens d'inhibition 42, et permet en outre d'éviter une commande parasite de la bobine électromagnétique 30 de l'actionneur lorsque le disjoncteur a été déclenché suite à la détection d'un défaut différentiel, et protège ainsi davantage la bobine électromagnétique 30. Autrement dit, l'interrupteur auxiliaire 150 permet de confirmer l'ouverture du ou des contacts mobiles 16 du disjoncteur.

En variante ou en complément non représenté, le dispositif de protection différentielle 22 comporte un interrupteur auxiliaire connecté entre le circuit d'alimentation 38 et les moyens de détection et de pilotage 36, ledit interrupteur auxiliaire étant commandé par l'actionneur de déclenchement 20. Selon cette variante, cet interrupteur auxiliaire permet en outre, lorsqu'il est dans un état non-passant, de couper l'alimentation des moyens de détection et de pilotage 36, ce qui engendre le blocage de l'organe de commande 34 et protège ainsi davantage la bobine électromagnétique 30. Autrement dit, cet interrupteur auxiliaire permet également de confirmer l'ouverture du ou des contacts mobiles 16 du disjoncteur après un déclenchement suite à la détection d'un défaut différentiel en évitant une commande parasite de la bobine électromagnétique 30.

Le ou les interrupteurs auxiliaires 150 selon ce cinquième mode de réalisation se distinguent d'un interrupteur auxiliaire de puissance qui serait connecté directement entre les conducteurs électriques 12, puisqu'ils ne sont pas connectés directement entre les conducteurs électriques 12, et sont prévus pour interrompre le passage d'un courant de faible puissance, tel qu'un courant inférieur à 10 mA, et non le passage d'un courant de forte puissance, à savoir celui circulant à travers les conducteurs électriques 12, tel qu'un courant supérieur à 500 mA. Le dispositif de protection différentielle 22 est donc également peu coûteux selon ce cinquième mode de réalisation, puisqu'il ne nécessite pas d'ajouter un interrupteur auxiliaire de puissance connecté directement entre les conducteurs électriques 12.

On conçoit ainsi que le dispositif de protection différentielle 22 selon l'invention permettant d'éviter une destruction de l'actionneur 20 lors de l'apparition d'un défaut électrique lorsque l'appareil de coupure électrique 10 est connecté à l'envers.

## Revendications

1. Dispositif de protection différentielle (22) pour un appareil de coupure électrique (10), l'appareil de coupure (10) comportant au moins un contact fixe (14) apte à être connecté à un conducteur électrique (12) correspondant, au moins un contact mobile (16), chaque contact mobile (16) étant mobile entre une position fermée, dans laquelle il est relié électriquement au contact fixe (14) correspondant, et une position ouverte, dans laquelle il est isolé électriquement du contact fixe (14) correspondant, et un actionneur (20) de déclenchement de l'ouverture du ou des contacts mobiles (16) lorsqu'un défaut différentiel est détecté,
le dispositif de protection différentielle (22) comprenant :
- un organe (34) de commande de l'actionneur de déclenchement (20),
**caractérisé en ce qu'**il comprend en outre des moyens (40) de mesure d'une grandeur électrique associée à l'organe de commande (34) et des moyens (42) d'inhibition de l'organe de commande (34) lorsque la grandeur électrique mesurée vérifie un critère prédéterminé, les moyens d'inhibition (42) étant adaptés pour forcer le passage de l'organe de commande (34) vers un état non-passant, quel que soit un ordre de commande éventuellement reçu par des moyens de détection (36) du défaut différentiel et de pilotage de l'organe de commande (34).

2. Dispositif (22) selon la revendication 1, dans lequel la grandeur électrique mesurée est un courant propre à circuler dans l'organe de commande (34).

3. Dispositif (22) selon la revendication 1, dans lequel l'organe de commande (34) comporte deux électrodes de conduction et une électrode de commande, et la grandeur électrique mesurée est une tension de l'organe de commande (34), mesurée entre deux électrodes parmi les électrodes de l'organe de commande (34).

4. Dispositif (22) selon l'une quelconque des revendications précédentes, dans lequel l'organe de commande (34) est un interrupteur statique, de préférence un élément choisi parmi le groupe consistant en : un transistor à effet de champ à grille isolée, un transistor bipolaire (144), un transistor bipolaire à grille isolée et un thyristor (44).

5. Dispositif (22) selon la revendication 3, dans lequel l'organe de commande (34) est un thyristor (44), et la jonction entre la gâchette du thyristor (44) et la cathode du thyristor (44) forme une diode, et les moyens de mesure (40) sont propres à mesurer un courant via la tension aux extrémités de ladite diode.

6. Dispositif (22) selon la revendication 3, dans lequel l'organe de commande (34) est un transistor, tel qu'un transistor à effet de champ à grille isolée, un transistor bipolaire (144) ou un transistor bipolaire à grille isolée, et les moyens de mesure (40) sont propres à mesurer un courant via la tension entre l'électrode de commande et l'électrode de drain ou d'émetteur dudit transistor.

7. Dispositif (22) selon l'une quelconque des revendications précédentes, dans lequel les moyens de détection et de pilotage (36) étant aptes à être connectés à un tore de mesure (18) et à fournir un signal de commande à l'organe de commande (34) lorsqu'un défaut différentiel est détecté, et les moyens d'inhibition (42) sont propres, lorsque la grandeur électrique mesurée vérifie le critère prédéterminé, à inhiber l'organe de commande (34) quel que soit le signal de commande fourni à l'organe de commande (34) par les moyens de détection et de pilotage (36).

8. Dispositif (22) selon la revendication 7, dans lequel les moyens d'inhibition (42) comportent un commutateur (90) connecté en série entre les moyens de détection et de pilotage (36) et une électrode de commande de l'organe de commande (34), le commutateur (90) étant ouvert pour inhiber l'organe de commande (34).

9. Dispositif (22) selon la revendication 7, dans lequel les moyens d'inhibition (42) comportent un commutateur (98) connecté entre une électrode de commande et une électrode de conduction de l'organe de commande (34), le commutateur (98) étant fermé pour inhiber l'organe de commande (34).

10. Dispositif (22) selon la revendication 7, dans lequel les moyens d'inhibition (42) comportent un transistor à collecteur ouvert, connecté entre une électrode de commande et une électrode de conduction de l'organe de commande (34), le transistor à collecteur ouvert étant passant pour inhiber l'organe de commande (34).

11. Dispositif (22) selon l'une quelconque des revendications précédentes, dans lequel le critère prédéterminé est le dépassement d'un seuil, et le seuil présente une valeur prédéterminée de sorte que l'organe de commande (34) est inhibé par les moyens d'inhibition (42) après que l'actionneur a déclenché l'ouverture des contacts mobiles (16) en cas de détection d'un défaut différentiel.

12. Dispositif (22) selon l'une quelconque des revendications précédentes, dans lequel les moyens de mesure (40) comportent un organe (54) de filtrage de la grandeur électrique, l'organe de filtrage (54) comportant de préférence une résistance (60) et un condensateur (62).

13. Dispositif (22) selon l'une quelconque des revendications précédentes, dans lequel les moyens d'inhibition (42) comportent un comparateur à hystérésis (56) connecté en sortie des moyens de mesure (40).

14. Appareil de coupure électrique (10), comprenant :
- au moins deux conducteurs électriques (12),
- au moins un contact fixe (14) connecté à un conducteur électrique (12) correspondant,
- au moins un contact mobile (16), le ou chaque contact mobile (16) étant mobile entre une position fermée, dans laquelle il est relié électriquement au contact fixe (14) correspondant, et une position ouverte, dans laquelle il est isolé électriquement du contact fixe (14) correspondant,
- un tore (18) de mesure du courant différentiel, le tore (18) entourant les conducteurs électriques (12),
- un actionneur (20) de déclenchement de l'ouverture du ou des contacts mobiles (16) lorsqu'un défaut différentiel est détecté via le tore de mesure (18), et
- un dispositif de protection différentielle (22) connecté au tore de mesure (18) et à l'actionneur de déclenchement (20),
**caractérisé en ce que** le dispositif de protection différentielle (22) est conforme à l'une quelconque des revendications précédentes.

15. Appareil (10) selon la revendication 14, dans lequel l'actionneur (20) comporte une bobine électromagnétique (30), une extrémité de la bobine électromagnétique (30) étant connectée à l'organe de commande (34).

## Patentansprüche

1. Fehlerstromschutzvorrichtung (22) für eine elektrische Schaltvorrichtung (10), wobei die Schaltvorrichtung (10) umfasst mindestens einen festen Kontakt (14), der geeignet ist, mit einem korrespondierenden elektrischen Leiter (12) verbunden zu werden, mindestens einen beweglichen Kontakt (16), wobei jeder bewegliche Kontakt (16) zwischen einer Schließstellung, in der er elektrisch mit dem korrespondierenden festen Kontakt (14) verbunden ist, und einer Offenstellung, in der er elektrisch von dem korrespondierenden festen Kontakt (14) isoliert ist, beweglich ist, und ein Betätigungselement (20) zum Auslösen des Öffnens des oder der beweglichen Kontakte (16), wenn ein Fehlerstrom detektiert wird,
wobei die Fehlerstromschutzvorrichtung (22) umfasst:
- ein Element (34) zum Steuern des Betätigungselements (20) zum Auslösen,
**dadurch gekennzeichnet, dass** außerdem Mittel (40) zum Messen einer dem Steuerelement (34) zugeordneten elektrischen Größe und Mittel (42) zum Sperren des Steuerelements (34), wenn die gemessene elektrische Größe ein vorbestimmtes Kriterium bestätigt, umfasst, wobei die Sperrmittel (42) angepasst sind, den Übergang des Steuerelements (34) in einen nichtleitenden Zustand zu erzwingen, wie auch immer ein Steuerbefehl sei, der gegebenenfalls von Mitteln (36) zum Abtasten des Fehlerstroms und des Steuerns des Steuerelements (34) empfangen wird.

2. Vorrichtung (22) nach Anspruch 1, bei der die gemessene elektrische Größe ein Strom ist, der geeignet ist, durch das Steuerelement (34) zu fließen.

3. Vorrichtung (22) nach Anspruch 1, bei der das Steuerelement (34) zwei leitende Elektroden und eine Steuerelektrode aufweist und die gemessene elektrische Größe eine Spannung des Steuerelements (34) ist, die zwischen zwei Elektroden der Elektroden des Steuerelements (34) gemessen wird.

4. Vorrichtung (22) nach einem beliebigen der vorhergehenden Ansprüche, bei der das Steuerelement (34) ein Halbleiterelement ist, vorzugsweise ein Element, das aus der Gruppe ausgewählt ist, die gebildet ist aus: Feldeffekttransistor mit isoliertem Gate, Bipolartransistor (144), Bipolartransistor mit isoliertem Gate und Thyristor (44).

5. Vorrichtung (22) nach Anspruch 3, bei der das Steuerelement (34) ein Thyristor (44) ist und die Verbindung zwischen dem Gate des Thyristors (44) und der Kathode des Thyristors (44) eine Diode bildet, und die Mittel (40) zum Messen geeignet sind, einen Strom über die Spannung an den Enden dieser Diode zu messen.

6. Vorrichtung (22) nach Anspruch 3, bei der das Steuerelement (34) ein Transistor ist, wie ein Feldeffekttransistor mit isoliertem Gate, ein Bipolartransistor (144) oder ein Bipolartransistor mit isoliertem Gate, und die Mittel (40) zum Messen geeignet sind, einen Strom über die Spannung zwischen der Steuerelektrode und der Drainelektrode oder dem Emitter des Transistors zu messen.

7. Vorrichtung (22) nach einem beliebigen der vorhergehenden Ansprüche, bei der die Mittel (36) zum Abtasten und zum Steuern geeignet sind, an einen Ringkern-Messstromwandler (18) angeschlossen zu werden und ein Steuersignal an das Steuerelement (34) zu liefern, wenn ein Fehlerstrom detektiert wird, und die Sperrmittel (42) geeignet sind, das Steuerelement (34), wie auch immer das Steuersignal sei, das von den Mitteln (36) zum Abtasten und Steuern an das Steuerelement (34) geliefert wird, zu sperren, wenn die gemessene elektrische Größe das vorbestimmte Kriterium bestätigt.

8. Vorrichtung (22) nach Anspruch 7, bei der die Sperrmittel (42) einen Schalter (90) aufweisen, der in Reihe zwischen die Mittel (36) zum Abtasten und Steuern und eine Steuerelektrode des Steuerelements (34) geschaltet ist, wobei der Schalter (90) zum Sperren des Steuerelements (34) offen ist.

9. Vorrichtung (22) nach Anspruch 7, bei der die Sperrmittel (42) einen Schalter (98) aufweisen, der zwischen eine Steuerelektrode und eine leitenden Elektrode des Steuerelements (34) geschaltet ist, wobei der Schalter (98) zum Sperren des Steuerelements (34) geschlossen ist.

10. Vorrichtung (22) nach Anspruch 7, bei der die Sperrmittel (42) einen Transistor mit offenem Kollektor aufweisen, der zwischen eine Steuerelektrode und eine leitende Elektrode des Steuerelements (34) geschaltet ist, wobei der Transistor mit offenem Kollektor zum Sperren des Steuerelements (34) leitend ist.

11. Vorrichtung (22) nach einem beliebigen der vorhergehenden Ansprüche, bei der das vorbestimmte Kriterium das Überschreiten einer Schwelle ist und die Schwelle einen vorbestimmten Wert aufweist, derart, dass das Steuerelement (34) von den Sperrmitteln (42) gesperrt wird, nachdem das Betätigungselement das Öffnen der beweglichen Kontakte (16) im Fall der Detektion eines Fehlerstroms ausgelöst hat.

12. Vorrichtung (22) nach einem beliebigen der vorhergehenden Ansprüche, bei der die Mittel (40) zum Messen ein Element (54) zum Filtern der elektrischen Größe aufweisen, wobei das Filterelement (54) vorzugsweise einen Widerstand (60) und einen Kondensator (62) umfasst.

13. Vorrichtung (22) nach einem beliebigen der vorhergehenden Ansprüche, bei der die Sperrmittel (42) einen Komparator (56) mit Hysterese aufweisen, der an den Ausgang der Mittel (40) zum Messen angeschlossen ist.

14. Elektrische Schaltvorrichtung (10), umfassend:
- mindestens zwei elektrische Leiter (12),
- mindestens einen festen Kontakt (14), der mit einem korrespondierenden elektrischen Leiter (12) verbunden ist,
- mindestens einen beweglichen Kontakt (16), wobei der oder jeder bewegliche Kontakt (16) zwischen einer Schließstellung, in der er elektrisch mit dem korrespondierenden festen Kontakt (14) verbunden ist, und einer Offenstellung, in der er elektrisch von dem korrespondierenden festen Kontakt (14) isoliert ist, beweglich ist,
- einen Ringkern-Stromwandler (18) zum Messen eines Fehlerstroms, wobei der Ringkern-Stromwandler (18) die elektrischen Leiter (12) umgibt,
- ein Betätigungselement (20) zum Auslösen des Öffnens des oder der beweglichen Kontakte (16), wenn ein Fehlerstrom über den Ringkern-Stromwandler zum Messen (18) detektiert wird, und
- eine Fehlerstromschutzvorrichtung (22), die mit dem Ringkern-Stromwandler (18) zum Messen und dem Betätigungselement (20) zum Auslösen verbunden ist,
**dadurch gekennzeichnet, dass** die Fehlerstromschutzvorrichtung (22) nach einem beliebigen der vorhergehenden Ansprüche ausgebildet ist.

15. Schaltvorrichtung (10) nach Anspruch 14, bei der das Betätigungselement (20) eine elektromagnetische Spule (30) umfasst, wobei ein Ende der elektromagnetischen Spule (30) mit dem Steuerelement (34) verbunden ist.

## Claims

1. A differential protection device (22) for an electric disconnecting apparatus (10), the disconnecting apparatus (10) comprising at least one fixed contact (14) suitable for being connected to a corresponding electrical conductor (12), at least one movable contact (16), each movable contact (16) being movable between a closed position, wherein it is electrically connected to the corresponding fixed contact (14), and an open position, wherein it is electrically isolated from the corresponding fixed contact (14), and an actuator (20) for activating the opening of the movable contacts (16) when a differential fault is detected,
the differential protection device (22) comprising:
- a control member (34) for controlling the actuator (20),
**characterised in that** it further comprises measuring means (40) for measuring an electrical variable associated with the control member (34) and inhibiting means (42) for inhibiting the control member (34) when the measured electrical variable satisfies a predetermined criterion, the inhibiting means (42) being adapted for overriding command of the control member 34 to a non-conducting state, whatever be a command order eventually received by detecting and driving means (36) for detecting a differential fault and for driving the control member (34).

2. The device (22) according to claim 1, wherein the measured electrical variable is a current adapted for flowing through the control member (34).

3. A device (22) according to claim 1, wherein the control member (34) includes two conducting electrodes and one control electrode, and the measured electrical variable is a voltage of the control member (34), measured between two electrodes among the electrodes of the control member (34).

4. A device (22) according to any one of the preceding claims, wherein the control member (34) is a static switch, preferably an element selected from the group consisting of: an insulated gate field effect transistor, a bipolar transistor (144), an insulated gate bipolar transistor, and a thyristor (44).

5. A device (22) according to claim 3, wherein the control member (34) is a thyristor (44), and the junction between the gate terminal of the thyristor (44) and the cathode of the thyristor (44) forms a diode, and the measuring means (40) are adapted for measuring a current via the voltage at the ends of said diode.

6. A device (22) according to claim 3, wherein the control member (34) is a transistor, such as an insulated gate field effect transistor, a bipolar transistor (144) or an insulated gate bipolar transistor, and the measuring means (40) are adapted for measuring a current via the voltage between the control electrode and the drain electrode or the emitter electrode of said transistor.

7. A device (22) according to any one of the preceding claims, wherein the detecting and driving means (36) are adapted for being connected to a measuring toroid (18) and providing a control signal to the control member (34) when a differential fault is detected, and the inhibiting means (42) are adapted, when the measured electrical variable satisfies the predetermined criterion, for inhibiting the control member (34) whatever may be the control signal supplied to the control member (34) by the detecting and driving means (36).

8. A device (22) according to claim 7, wherein the inhibiting means (42) comprise a switch (90) connected in series between the detecting and driving means (36) and a control electrode of the control member (34), the switch (90) being open in order to inhibit the control member (34).

9. A device (22) according to claim 7, wherein the inhibiting means (42) comprise a switch (98) connected between a control electrode and a conduction electrode of the control member (34), the switch (98) being closed in order to inhibit the control member (34).

10. A device (22) according to claim 7, wherein the inhibiting means (42) comprise an open collector transistor, connected between a control electrode and a conduction electrode of the control member (34), the open collector transistor being turned on in order to inhibit the control member (34).

11. A device (22) according to any one of the preceding claims, wherein the predetermined criterion is the exceeding of a threshold, and the threshold has a predetermined value such that the control member (34) is inhibited by the inhibiting means (42) after the actuator has activated the opening of the movable contacts (16) in case of detection of a differential fault.

12. A device (22) according to any one of the preceding claims, wherein the measuring means (40) comprise a filter member (54) for filtering the electrical variable, the filter member (54) preferably comprising a resistor (60) and a capacitor (62).

13. A device (22) according to any one of the preceding claims, wherein the inhibiting means (42) comprise a hysteresis comparator (56) connected to the output of the measuring means (40).

14. An electric disconnecting apparatus (10), comprising:
- at least two electrical conductors (12),
- at least one fixed contact (14) connected to a corresponding electrical conductor (12),
- at least one movable contact (16), the or each movable contact (16) being movable between a closed position, wherein it is electrically connected to the corresponding fixed contact (14), and an open position, wherein it is electrically isolated from the corresponding fixed contact (14),
- a measuring toroid (18) for measuring the differential current, the toroid (18) surrounding the electrical conductors (12),
- an actuator (20) for activating the opening of the movable contact or contacts (16) when a differential fault is detected via the measuring toroid (18), and
- a differential protection device (22) connected to the measuring toroid (18) and to the actuator (20),
**characterised in that** the differential protection device (22) is in accordance with any one of the preceding claims.

15. An apparatus (10) according to claim 14, wherein the actuator (20) includes an electromagnetic coil (30), one end of the electromagnetic coil (30) being connected to the control member (34).
